Europäisches Patentamt

European Patent Office

Office européen des brevets

(11) Publication number: **0 322 205**
**A2**

# EUROPEAN PATENT APPLICATION

(21) Application number: **88312104.8**

(22) Date of filing: **21.12.88**

(51) Int. Cl.⁴: **H 01 L 21/00**

(30) Priority: **23.12.87 US 137545    01.04.88 US 176809**

(43) Date of publication of application:
**28.06.89  Bulletin  89/26**

(84) Designated Contracting States: **DE FR GB IT NL**

(71) Applicant: **TEXAS INSTRUMENTS INCORPORATED**
**13500 North Central Expressway**
**Dallas Texas 75265  (US)**

(72) Inventor: **Foster, Leonard W.**
**1316 Grinnell Drive**
**Richardson Texas 75081  (US)**

**Moreland, James R.**
**2008 Lakeshore Lane**
**Plano Texas 75023  (US)**

**Sullivan, Harold W.**
**14505 Ablon**
**Dallas Texas 75081  (US)**

(74) Representative: **Abbott, David John et al**
**Abel & Imray Northumberland House 303-306 High**
**Holborn**
**London, WC1V 7LH  (GB)**

(54) **Automated photolithographic work cell.**

(57) Disclosed is an environmentally controlled work cell 200 including a robotic arm to transport semiconductor wafers one at a time between multi-level process stations within the work cell. The work cell receives a clean air supply from overhead air handlers which direct clean air 301 into the interior of the work cell, through the open top of the work cell 200. the overhead air handlers can be modular units which direct clean air only into the interior of the work cell 200, and, possibly, into the areas immediately surrounding the work cell. The overhead air handlers also can be large in extent, supplying clean air to most of the entire room in which the work cell is located.

Figure 9

Description

## AUTOMATED PHOTOLITHOGRAPHIC WORK CELL

### CROSS-REFERENCE TO RELATED APPLICATIONS

This Patent Application is a continuation-in-part of U.S. Patent Application Serial No. 137,545 filed December 23, 1987.

This Patent Application is related to the following U.S. Patent Applications assigned to Texas Instruments Incorporated: Serial No. 089,896 filed August 27, 1987; and Serial No. 093,327 filed September 4, 1987.

### FIELD OF THE INVENTION

This invention relates to semiconductor wafer processing, and more particularly to an automated system and process for wafer-at-a-time handling of semiconductor wafers within a single process module or work cell.

### DISCUSSION OF PRIOR ART

Current state-of-the-art semiconductor process machines utilize wafer cassette elevators or indexers and a multiplicity of wafer handling mechanisms to move wafers, one at a time, from one process station to another within a given machine. Wafers are most generally moved from one machine to another in batches or lots of 25 or 50 wafers using cassette wafer holders.

Current process machines frequently only have one process station per machine and therefore, two wafer cassette loader/unloader mechanisms, and at least two wafer transport mechanisms are used to unload/transport the wafer to the process station and to transport/load the wafer after processing.

Many photoresist process machines are configured with several process stations within a given machine, and in these machines there are more transport mechanisms and sensors between the process stations than in a single process station machine. The more mechanisms, the more chances there are for failures and more requirements for maintaining of adjustments for proper performance. The more wafer handling mechanisms, the more elements that contact the wafers, and therefore, the more elements that must be kept clean to control contamination.

In the past, semiconductor process equipment has featured wafer cassette elevators or indexers, motor driven rubber belts, air tracks, and some pick and place mechanisms to accomplish wafer handling. In recent years, equipment vendors have begun to use more pick and place mechanisms in order to achieve cleaner wafer handling. In some cases, pick and place mechanisms have been distributed between process stations to accomplish the movement of wafers through a series of process steps or stations. However, the ratio of wafer handlers to process stations has remained at 1:1 or 2:1 or greater.

Also, in recent years, multiple degree-of-freedom robot arms have been used to move single wafers and cassettes of wafers. When single wafers have been moved using a robot arm, the ratio of wafer handlers to process stations support has not been lower than 1:3, and the robot arm has been only one of several wafer handling mechanisms used to accomplish the process flow. When robot arms have been used to move cassettes of wafers, no reduction in wafer handling mechanisms has been intended or accomplished.

### BRIEF DESCRIPTION OF THE INVENTION

The invention is a photolithographic work cell including a clean, reliable, multiple degree-of-freedom robot arm or arms to unload semiconductor wafers from stationary cassettes and transport the wafers one wafer at a time from one process machine (station) to another within a robot work cell arrangement, and reload the wafers into cassettes.

The work cell is configured with process stations that best accomplish the semiconductor production process flow desired. The production cycle times of the individual process stations are matched with each other and with the speed of the robot arm to meet the overall production throughput requirement for the work cell. Cassette load stands hold the wafer cassettes in stationary positions for the wafer unloading/loading from and to the cassettes.

Dedicated wafer handling mechanisms such as cassette loader/unloader or any other redundant handling mechanisms are removed from the process machines wherever possible, leaving only the essential process stations. The ratio of wafer handlers to process stations for the photolithography cells designed thus far have been in the range of 1:3 to 1:11 depending upon the number of process steps needed.

A host controller/computer is used to communicate with the process station and robot in the work cell, and to coordinate the operation of the robot arm(s) with the wafer processing cycles of each process station. The computer operating software is designed to allow flexibility in the process definitions, selection, and ordering of the process steps to be accomplished in the work cell. The host controller/computer is the CPU for all process stations in the cell, and may be located outside the cell for ease of maintenance.

The work cell process machines and robot arm(s) are enclosed in a largely continuous particle shield, transparent plastic safety wall to provide an ultra-clean wafer process environment, there being no operator personnel inside the cell, and to provide a safety barrier for limiting personnel access to the robot arm when it is operating. The particle shield/safety wall has openings to permit access to the process machines for servicing.

The machines may be designed with integral shield/wall elements to facilitate the forming of the overall cell shield/wall when the machines are installed in the work cell. An access door with a robot shut-off interlock switch is provided for personnel access to the inside of the cell, and to the robot arm manipulator. The robot arm controller unit is located outside the cell wall boundaries for ease of maintenance access.

The process machines to be used in the work cell are designed to afford machine servicing primarily from one or two sides of each machine. The process station units within a machine may be designed to be modular subassemblies with quick release facilities/communication connections to accomplish rapid change out and repair. The process stations are arranged in a plane around a robot arm, and are also stacked in some instances to provide more process stations within the work cell. The robot arm is indexed both vertically and horizontally to deliver semiconductor wafers to and from each process to the next station or to a wafer cassette.

The invention may be applied to most of the process machines used in semiconductor front ends and may be used as a basic building block element of an overall wafer fabrication facility approach, and as such, the cell host controller would be connected with the wafer fabrication factory control network and factory computer.

The technical advance represented by the invention as well as the objects thereof will become apparent from the following description of a preferred embodiment of the invention when considered in conjunction with the accompanying drawings, and the novel features set forth in the appended claims.

BRIEF DESCRIPTION OF THE DRAWINGS

FIGURE 1 is a diagram of process flow of the prior art;

FIGURE 2 is a process flow diagram of the present invention;

FIGURE 3 illustrates the photolithographic work cell layout of the present invention;

FIGURE 4 is a work flow diagram of the work cell of Figure 3;

FIGURE 5 illustrates stacked work stations;

FIGURES 6a - 6f illustrate a robot arm and end effector used to move semiconductor wafers around the work cell;

FIGURE 7 is a pictorial illustration of a work cell; and

FIGURE 8 illustrates a photolithographic work cell layout using two robot arms.

FIGURE 9 is a side elevation showing an embodiment of the invention.

FIGURE 10 is a side elevation showing an embodiment of the invention.

FIGURE 11 is a side elevation showing an embodiment of the invention.

FIGURE 12 is a side elvation showing an embodiment of the invention.

FIGURE 13 is a side elevation showing an embodiment of the invention.

DESCRIPTION OF A PREFERRED EMBODIMENT

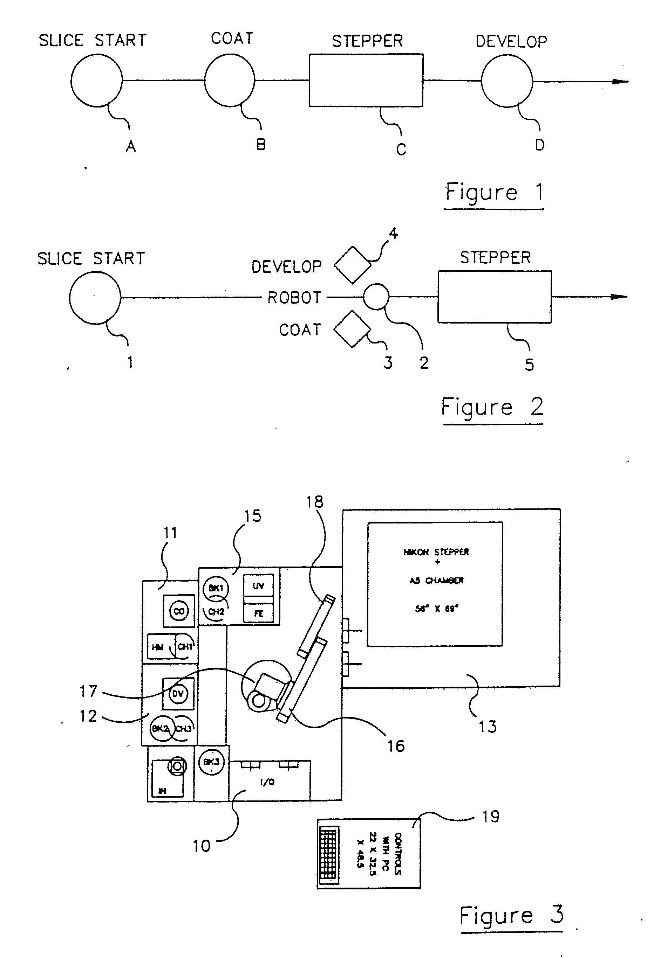

Figure 1 is a process flow diagram of a typical prior art photolithographic process for semiconductor devices. A lot of semiconductor wafers, typically 25 to 50, enters the process flow at station A and is transported to station B where the wafers are coated with photoresist polymer, one at a time.

Next the lot of semiconductor wafers is moved to a stepper (or printer) station C where the photoresist on each wafer is exposed to image patterns in the photoresist. The wafer has to be "stepped" to expose multiple device patterns on the wafer, the number of patterns dependent upon the number of semiconductor devices that are to be produced from the semiconductor wafer. After latent pattern images are produced in the photoresist, the image has to be developed at station D to remove photoresist polymer from the areas on the wafer defined by the imaging process. Since the process flow is sequential, a wafer lot must be completely processed at each station before the next wafer lot can be processed.

Figure 2 illustrates a process flow that may be used with the present invention. A semiconductor wafer lot enters the process at station 1. A robot arm 2 transports the first wafer to the coat station 3. After coating, the wafer is moved by the robot arm 2 to the stepper/printer station 5. A second wafer is moved from station 1 to the coat station 3 by the robot arm 2.

After imaging in the stepper station 5, the robot moves the first wafer to the develop station 4. As soon as a wafer is removed from one station, the robot arm 2 moves the next wafer to the station to be processed. In this manner, process stations are processing wafers concurrently. Since wafer lot queuing between process stations is eliminated, the overall production time for the series of process steps is considerably reduced. Note that the photolithographic work cell can also be used with a projection printer or an electron beam pattern writing machine.

Figure 3 illustrates the lay out of the photolithographic work cell of the present invention. The input unit 10 (I/O) is used for cassette input to the work cell. Each cassette holds a plurality of semiconductor wafers to be processed. Since station 10 is for both input and output, at least two cassettes are present, one to hold unprocessed wafers and a second one to receive processed wafers. Robot arm l6, rotating on base 17, picks up a wafer (not illustrated) with arm end effector 18 and moves it to unit 11 (Station 1).

At station 1(position labeled HM) the wafer is coated with HMDS hexamethyldisilazane. The wafer is next moved by arm 18 to a cool plate CH1. Cool plate CH1 is a station adjacent to and below the HM station. Arm 18 has a wide latitude of vertical motion as well as the capability of 360 degrees of rotation. Also, by stacking the work stations vertically, a smaller work cell is possible.

After cool station CH1, the wafer is coated with the photoresist polymer at station CO. The polymer coated wafer is moved to station 15 for a soft bake at BK1, then cooled at cool plate CH2. From cool plate CH2, the wafer is moved to the stepper/printer unit 13 where latent images are placed in the photoresist polymer on the wafer. From the stepper, the wafer is moved to a post bake unit BK2 and to cool plate CH3.

At this point in the process, the wafer, and the photoresist thereon, is ready for the develop process. The wafer is transferred to station 12, developer DV.

After the develop step, the wafer is field exposed with ultraviolet light at station 15, unit FE, and then transferred to unit BK3 for a hard bake. The wafer is inspected, if desired, at unit IN in station 14. Thereafter the wafer is moved to the output cassette at the I/O unit 10.

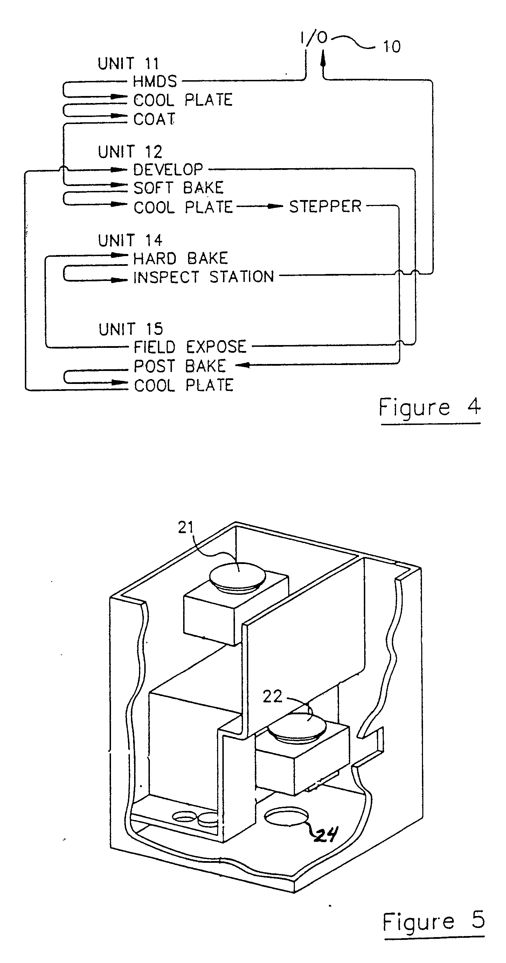

An alternate process flow within the work cell is illustrated in Figure 4. The wafer is moved from the I/O 10 to the HMDS coat station in unit 11. In unit 11 the wafer is moved from the HM unit to the cool plate CH1, and then to the coating unit CO. The wafer is now moved to unit 12 for a soft bake at BK2 and then to cool plate CH3.

From the cool plate CH3, the wafer is moved to the stepper unit 13 for image placement, and then to Unit 15 for a post bake in station BK1 and to cool plate CH2. Thereafter the wafer is placed in developer station DV in unit 2. The wafer is returned to station 15 for field expose FE. The wafer is then moved to station 14 for a final hard bake at station BK3 and inspection at station IN. Station IN is a sampled inspection station, and not all wafers are necessarily inspected. After inspection, the wafer is placed in the output cassette at I/O station 10.

To limit the work cell size and to provided efficient access to each station within each unit in the work cell, certain of the stations are stacked. Figure 5 illustrates a perspective view of a stacked work unit that may be accessed by the robot arm 18 from the front of of the work unit.

The robot arm 18 for a given work unit 20 can access the lower process station through access opening 24 to manipulate a work piece (wafer) on surface 22, or to access the upper work station to manipulate a work piece on the work surface. It can be seen that the robotic arm 18 needs only to move in the vertical and horizontal directions to access the two work surfaces 21 and 22. With the design of the present work cell, both the vertical and horizontal range of motion of the robotic arm 18 is being utilized, resulting in a more efficient use of both space and the robotic system. It should be noted that a baffle or partition 13 is used to separate the upper and lower work stations so that air flow from the upper work station does not flow across the lower work station.

The stacked work stations are more fully described and claimed in copending patent application Serial No. 089,896, filed August 27, 1987, and entitled STACKED ROBOTIC WORK CELL PROCESS STATION (T112738).

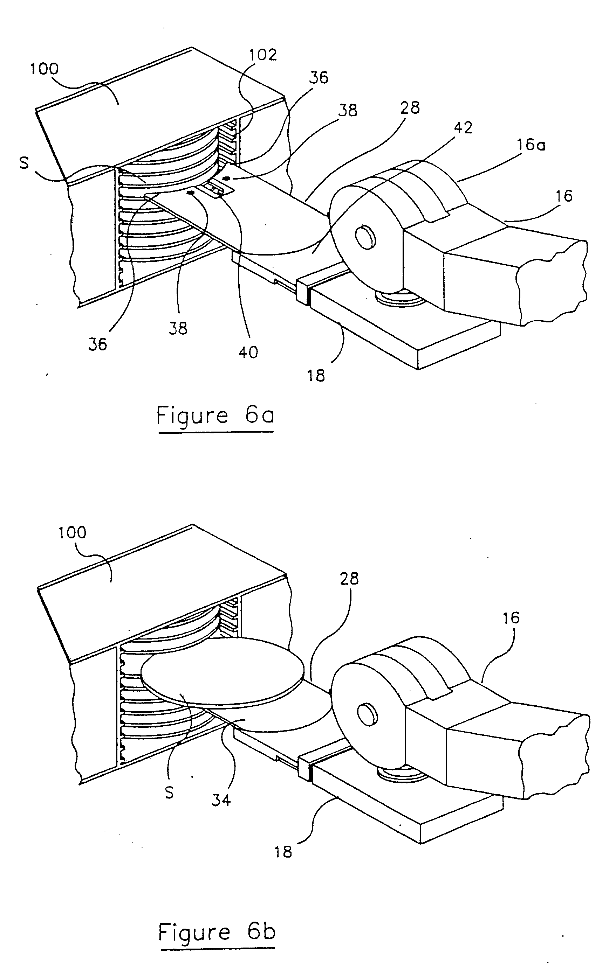

The positioning of the semiconductor wafer with the robotic arm is illustrated in Figures 6a through 6e. In these figures a plurality of wafer-postioning and transporting operations used in moving a semiconductor wafer through the work cell are illustrated.

Figure 6a illustrates the beginning steps in transferring wafer S from cassette 100 to another location.

Cassette 100 has a plurality of racks or slots 102 completely or partially filled with semiconductor wafers, including wafer S. At the beginning of the process, end effector platform 28 is in a horizontal position. Robot arm 16 inserts platform 28 into cassette 100 underneath wafer S. Platform 28 is diminsioned so as to be able to be inserted between wafers in cassette 100. At some point prior to picking up the wafer, a vacuum source for vacuum port 38 is turned on such that there is a continuous suction at these ports.

Looking at Figure 6b, robot arm 16 lifts platform 28 upward such that wafer S is supported on platform 28. In particular, enough of platform 28 is inserted underneath wafer S to give stable support to wafer S, particularly forks 36 (Figure 6a). Once wafer S makes contact with upper plate 34 of platform 28, the suction from ports 38 affixes wafer S in place relative to platform 28. Further, capacitive sensor 40 (Figure 6a) senses the presence of wafer S on the upper surface 34. Next, arm 16 is manipulated to elevate and withdraw platform 28, effector 18, and wafer S from Cassette 100.

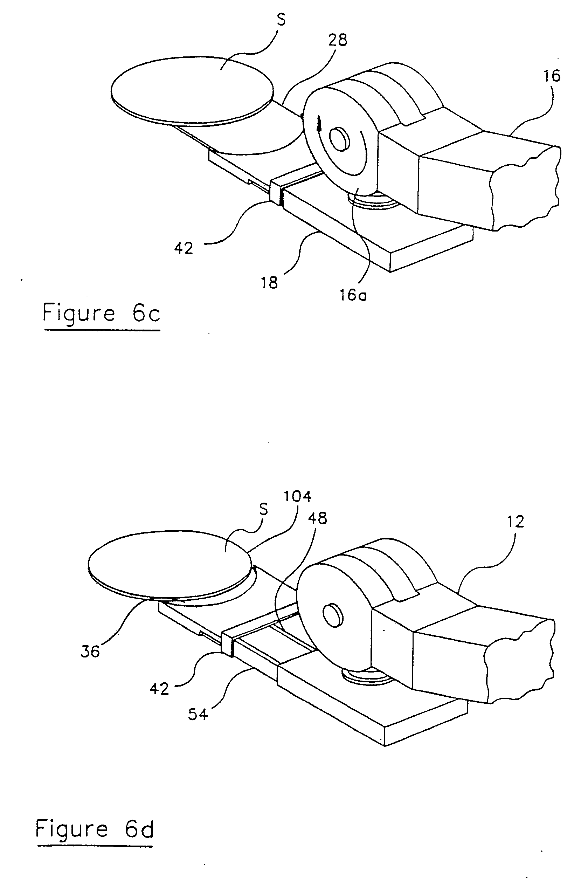

In Figure 6c, effector 18 and platform 28 are tilted in an upward direction away from the horizontal such that wafer S is in an inclined plane and above catcher 42. At this step, it is preferred that the vacuum into ports 38 be switched on such that the wafer S will adhere to a position on the end of platform 28.

This tilting action can take place while arm 16 is moving from cassette 100 to another desired position. The releasable affixation of wafer S to platform 28 by the vacuum allows this to be possible.

Turning to Figure 6d, after the wafer S is on the tilted platform 28, and affixed by the vacuum, then catcher 42 may be extended to stabilize wafer S. The vacuum source is turned off after catcher 42 is extended forward into an indexed position. Responsive to the cessation of vacuum at ports 38, wafer S will slide slightly downward and will be indexed or centered by the catcher 42. This perfectly aligns wafer S with catcher 42, and therefore effector 18 and arm 16. The robot control knows the precise location of its arm 16 and effector 18, and thus now knows exactly where wafer S is in relation to it. The robot can therefore place wafer S with precision at any desired location. After wafer S is positioned in relation to catcher 42, vacuum ports 38 are usually turned back on in order to reaffix wafer S to platform 28.

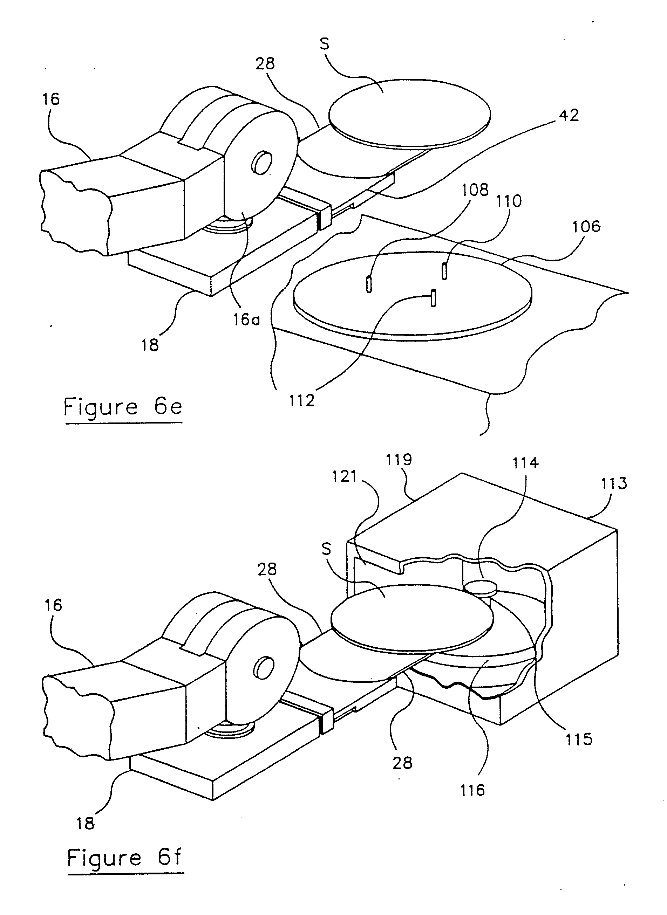

In Figure 6e, the final step in the transportation and centering process is illustrated. Catcher 42 preferably is retracted to a rest position either before or after pivot 16a returns blade 28 to a horizontal position. During or after this time, robot arm 16 moves end effector 18 to a second location, such as a hot plate bake machine indicated generally at 106 (referred to in Figure 3 as stations BKl, BK2 and BK3).

Robot arm 16 next lowers platform 28 and wafer S down on posts 108-112 of bake machine 106. One of the posts, post 108, is in line with the long axis center line of platform 28 as the robot arm lowers the platform 28 and wafer to the bake machine. Blade 28 is lowered past the upper point of center post 108, which passes within a channel provided within a capacitor sensor element ( at 40 of Figure 6a). In this way, wafer S can be placed on top of bake machine 106 while physically avoiding support post 108.

Figure 6f illustrates an alternate destination for wafer S. In this case a photoresist spinner indicated generally at 113 (station CO in Figure 3). End effector platform fingers are designed to "nest" around the spinner vacuum chuck.

Spinner 113 includes a spinner chuck 114 that is preferably in the form of a circular disc having a diameter substantially less than wafer S. A chuck support shaft 115 is affixed to the center of the bottom of disc 114, and is operable to impart rotational motion to disc 114 and to raise and lower it. Shaft 115 is elevated to the position shown in order to receive wafer S, and is retracted into a photoresist cup 116 in preparation for spinning photoresist onto the top surface of wafer S.

The robot arm end effector is described in more detail and claimed in copending patent application Serial No. 093,327, Filed September 4, 1987, and entitled ROBOT SLICE ALIGNING END EFFECTOR (TI12734).

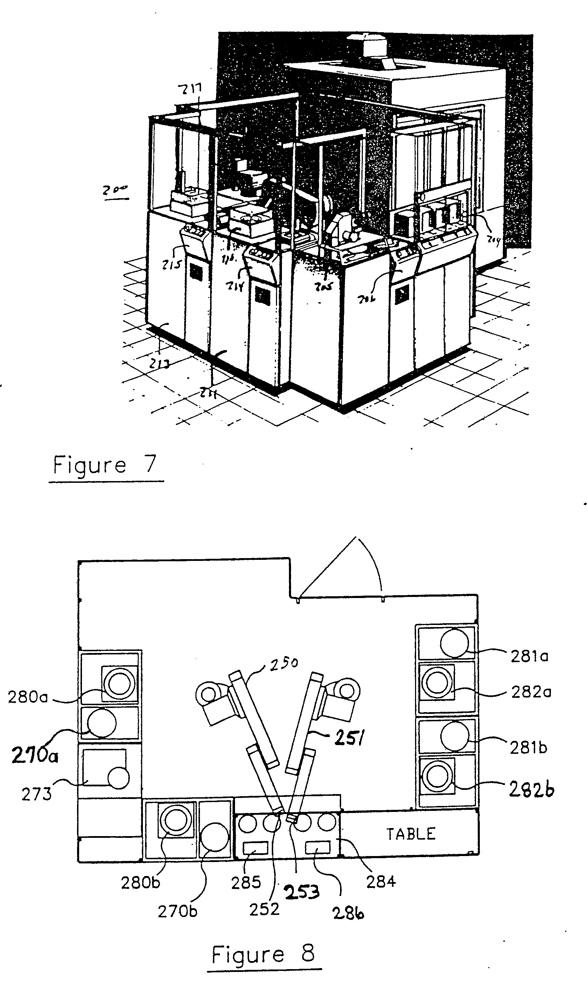

Figure 7 illustrates a pictorial illustration of a work cell of the present invention. Work cell 200 interior is environmentally partitioned from the exterior or operator environment around the cell so that it functions in a more controlled, highly clean air environment. The work cell 200 is controlled by computer(s) located in a console (not illustrated) which also includes a monitor and a key board for operator interactions. The construction of the work cell 200 is modular in form and, for example, has modules 211 and 213 on one side. There are keyboards 206, 215 and 214 that may be used to stop operation, change procedures, and in general provides for manual operation of any station within a given module in the work cell.

In the work cell illustrated, the input at which semiconductor cassettes are entered into the work cell is indicated at 204. A developer station 216, inspection station 205, and field exposure station 217 are shown.

Figure 8 illustrates the lay out of a work cell having two robotic arms. The input station 284 has at least two wafer cassettes 285 and 286. One robot arm moves a wafer S1 through the predevelop process steps. There are two coat/bake modules, and a wafer may be coated or baked at any of the bake or coat stations.

The process may be, for example, briefly described as follows. A wafer S1 is removed from a cassette, 285,286 is coated at coat station 281a or 281b, processed at a soft bake station 282a or 282b. Other process stations not specifically illustrated, such as HMDS coat and cool plate, may be under the illustrated stations, for example, stacked as in the work cell of Figure 3.

After the coating process is complete, robot arm 251, having end effector 253 moves the wafer S1 to the stepper/printer for imaging. After imaging, robot arm 250 and end effector 252 removes the wafer, now designated as S2. The coating is developed at develop station 280a or 280b and moved to station 270a or 270b where it is baked, and then inspected at inspection station 273. Upon completion of the inspection, the wafer S2 is moved to an out put cassette.

The process flow with regard to Figure 8 does not necessarily include all the possible process steps used in processing a semiconductor, but is for illustration purposes to show the cooperation between two robot arms to move a wafer through a work cell having two robotic arms in order to decrease the processing time through a work cell. The robotic arms can be processing several wafers at one time by moving them between the various process stations as each step in the process is completed. Wafers may be temporarily stored in a cassette if the work station required for the next process step for a particular wafer is occupied at the time the prior process step is completed.

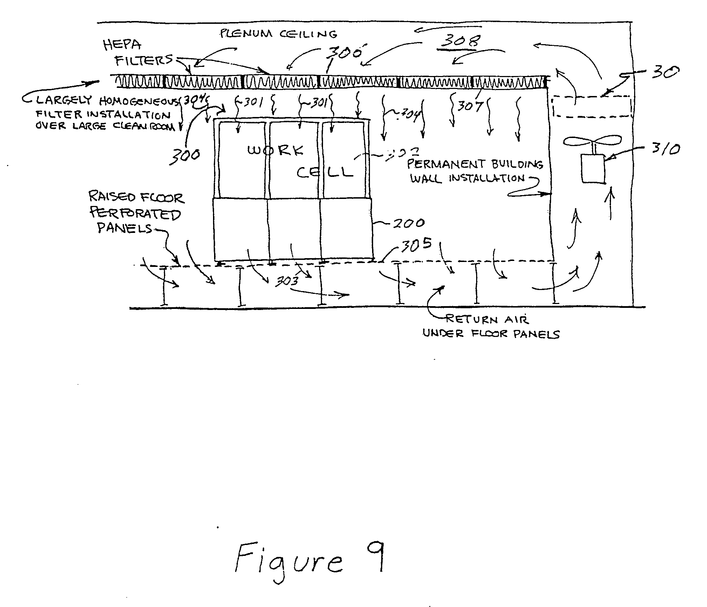

The invention comprehends that the clean air environment for a work cell 200 can be supplied and maintained by any one of several embodiments, including the ones shown in Figures 9-13. In the illustrated embodiments, a flow 301 of filtered, temperature and humidity controlled air is supplied to the open top 300 of the workcell 200. This clean air flow 301 is directed downward inside the work cell walls 302 and generally parallel to the walls. In this way, the air flowing through the work cell wafer handling and processing areas is iolated from sources of praticles outside the work cell, such as human operators, adjacent equipment and the like. The open top 300 of the work cell 200 is higher above the floor than are human operators and other sources of potential particulate contamination.

The flow 301 of clean air into the work cell 200, whether from a ceiling grid of High Efficiency Paticulate Air (HEPA, discussed more fully below) filters or from other means, must be balanced with the exhaust air303 from the work cell to maintain a slight positive pressure within the work cell. This positive pressure ensures an outward flow of air from the work cell through any openings, such as at the wafer input station 284, shown in Figure 8, where machine operations are done by a human operator. This outward flow of air from the work cell is needed to maintain the cleanliness inside the cell and to prevent migration into the work cell of particles from human operators and less-clean surrounding areas. The pressure difference between the inside and the outside of the work cell should be such as to cause a flow from the work cell of about one hundred feet per minute outward through any openings in the sides of the work cell.

A vertically downward flow 304 of clean air also can be supplied outside the work cell walls for the purposes of reducing particulate contamination in the areas outside the work cell proper, and of reducing the particle challenge level to the work cell walls 302. The ratio of clean air area outside the work cell walls 302 to the are within the work cell can range from zero to very large numbers, depending upon 1) the degree to which the outside particle challenge level needs to be controlled, and 2) the requirements for clean manufacturing space in the neighborhood of the work cells 200.

For purposes of discussing the following several embodiments of clean air supply for the work cell, the Overhead Filter Ratio (OFR) is defined as the area of the filtered air source for the flow 304 external to the work cell, divided by the area of the filtered air source for the flow 301 directly over the open top 300 of the work cell. I.e., OFR = OUTSIDE CLEAN AIR SOURCE AREA /INSIDE CLEAN AIR SOURCE AREA.

Figure 9 shows an embodiment of the invention in which the work cell 200 is installed on a raised, perforated floor and under a ceiling 306 which largely is populated with HEPA filters 307 through which the air flows 301 and 304, is moved in a downwardly vertical direction. The HEPA filters 307, in this embodiment, extend well beyond the bounds of the footprint of the work cell, and so supply air flow 304 outside the work cell 200, as well as the air flow 301 to the interior of the work cell. The clean air flow 301 to the interior of the work cell largely is made up of recirculated room air that is fed to the HEPA filters from a common plenum 308 above the HEPA filter 307 ceiling 306. With this embodiment, OFR = approximately ten or more. A fan 310 forces the returned air through the temperature and humidity control system 309, prior to entering the plenum 308.

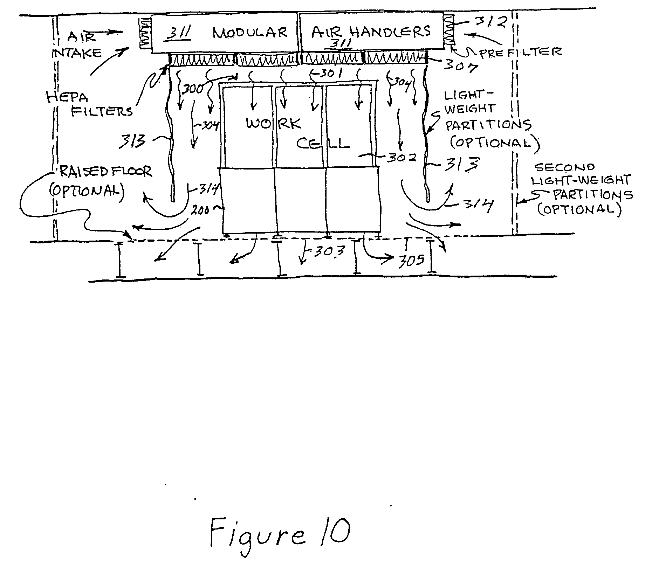

Figure 10 illustrates an embodiment of the invention in which clean air flows 301, 304 are supplied by standalone, modular air handlers 311 and HEPA filters 307 mounted above the work cell with a small percentage of the HEPA filter flow 304 extending beyond the footprint of the work cell. The air handlers 311 include prefilters 312. The space surrounding the work cell serves as the return air plenum. An optional light weight hanging patition 313 can be constructed around and offset from the work cell to channel the return air 314 to the air handlers 311. The wall partition 313 can be omitted , in which case the surrounding air space serves for loosely controlling the re-circulation of the return air. In this embodiment, OFR = approximately 0.1 to 0.5.

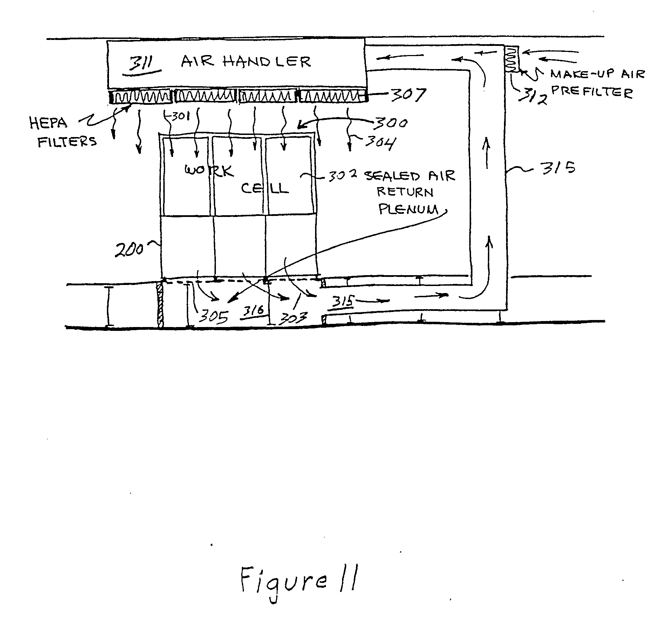

Figure 11 shows an embodiment similar to the embodiment of Figure 10, but with a dedicated air return duct 315 from below the work cell to the air handlers 311 and HEPA filters 307 above the work cell 200. Below the floor 305 is an enclosed plenum 316 to collect the air below and from the work cell, and to channel it to the air return duct 315.

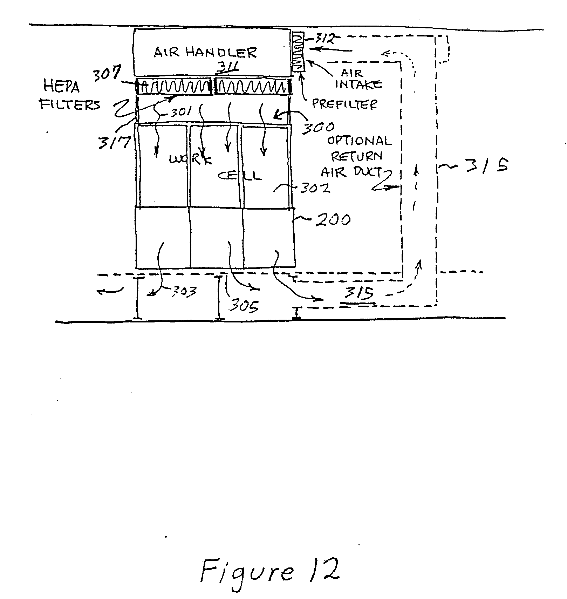

Figure 12 illustrates an embodiment of the invention which is similar to those shown in Figures 10 and 11, except that the HEPA filter air flow is limited to the flow 301 to the interior of the work cell. A partition 317 is provided to seal the open top 300 of the work cell to the output of the air handler 311, to prevent air other than air flow 301 from the HEPA filters 307, from reaching the interior of the work cell. In this embodiment, OFR = 0.

Another embodiment of the invention (not shown) which is similar to that shown in Figure 10, uses the room space external to the work cell as the return air plenum, and filtered air also is supplied to the exterior border areas of the work cell. Specifically, clean air is supplied to the exterior of the work cell at the positions used for operator inspection of wafers and loading of wafers to and from the work cell. In these specific areas, additional partitions or suitable heavy curtains can be used to channel and isolate the downward flow of air. In this embodiment, OFR = approximately 0.1 to 0.5.

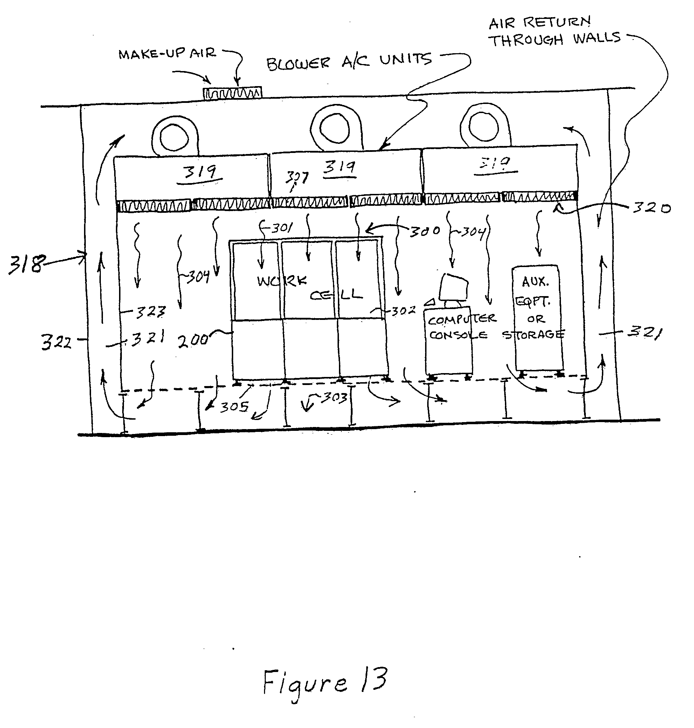

Figure 13 shows an embodiment of the invention in which the clean air is supplied by a small, modular clean room 318 with built-in air handlers 319, environmental control systems and a largely uniform HEPA filter 307 ceiling 320. Air return to the HEPA filter ceiling 320 generally is provided for by perforated, raised floor 305 and through a space 321 defined by outer 322 and inner 323 walls of the clean room 318. With this embodiment, OFR = approximately 0.5 to 10.

HEPA filters are able to filter out 99.99 percent of particulates from the air. HEPA filters are not as effective in filtering out particles less than approximately half a micron in diameter. The invention also can be implemented by using Ultra Low Penetration Air (ULPA) filters in place of the HEPA filters. ULPA filters remove 99.9995 percent of particulates from the air. Particles .12 microns and less in diameter are not as effectively filtered by ULPA filters.

The flow of clean, filtered and temperature and/or humidity conditioned air, commonly called "VLF" air for Vertical Laminar Flow, down through the work cell processing areas is controlled as to velocity and direction. The air enters the work cell from the open top 300, and moves vertically downward at a velocity generally between eighty and one hundred twenty feet per minute.

This flow velocity range is considered to be laminar, that is, that turbulence is absent or is minimized in the flow of air through the work cell. Turbulence is identified as air that is caught in an eddy or other circular path, and does not flow in one pass through the work cell. Turbulent air flow creates unpredicatable air flows that can sweep up particles from the equipment and transport the particles in such a way as to provide multiple opportunities for depositing the particles on the semiconductor wafers being processed in the work cell. Turbulence generally is caused by excessive velocity in the airflow.

If the air velocity downward through the work cell is appreciably less than eighty feet per minute, the velocity may not be sufficient to prevent the upward migartion of particles from the lower parts of the work cell. The velocity must be high enough to sweep the work cell clear of particles in the unlikely event that particles are generated by the work cell mechanisms in the lower sections of the work cell. If there is very limited particulate generation within the work cell, the vertical flow velocity may be able to be dropped to less than eighty feet per minute.

In the embodiments of the invention in which the work cell is free-standing with its walls 302 not sealed to the HEPA filters 307, it is important to have the direction of airflow from the ceiling to the perforated floor, vertical to within five or ten degrees. If the angle is greater, the flow into the top 300 of the work cell 200 on the upstream side, will cause a slight negative pressure inside the wall 302. This will cause contamination outside the work cell to be sucked in through any small cell wall openings, into the interior of the work cell.

The VLF airflows, return airflows and makeup air must be correctly balanced to give a slight internal pressure in the work cell to prevent the migration of particles from outside the work cell into the interior of the work cell.

## Claims

1. A work cell for handling semiconductor wafers in a clean room environment, comprising:
(a) an enclosure for providing an ultra clean work space;
(b) a plurality of work stations used in the photolithography processing of semiconductor wafers;
(c) a single robotic arm for moving semiconductor wafers to and from each of said plurality of work stations; and
(d) a controller unit for directing the movements of the robotic arm, operating the process stations and coordinating the overall operation of the work cell.

2. The work cell according to claim 1 including an input/output station for providing an access to the work cell and for removing processed semiconductor wafers.

3. The work cell according to claim 1 wherein said robotic arm accesses said work stations through rotation, vertical and horizontal movement.

4. The work cell according to claim 1 wherein said work stations are located in a first plane positioned around said robotic arm and in one or more additional plane vertically removed from said first plane.

5. The work cell according to claim 1 wherein the construction of said work cell is modular such that individual work stations may be accessed from the operator side(s) of the work cell and/or removed for repair and maintenance independent of the other work stations.

6. The work cell according to claim 5 including process units, each process unit including one or more work stations, each process unit providing a modular unit.

7. The work cell according to claim 6, wherein work stations in each process unit may be vertically displaced from each other in the process unit.

8. The work cell according to claim 1 wherein said controller is used to communicate with the process stations and the robotic arm in the work cell and to coordinate the operation of the robotic arm with the semiconductor wafer processing cycles of each process station.

9. The work cell according to claim 1 wherein said enclosure is made to form a particle shield and robot safety wall to provide an ultra-clean semiconductor process environment inside the work cell.

10. The work cell according to claim 7, wherein said robotic arm can access each process station in any sequence and omit process steps not required for a given overall process sequence.

11. A work cell system for processing semiconductor wafers in a clean air environment, comprising:
(a) a semiconductor wafer processing work cell having surrounding walls which define an open top;
(b) an air handler, positioned over the open top of the work cell, for supplying clean air to the interior of the work cell, through the open top.

12. The work cell system of claim 11, wherein the work cell includes:
(a) passageways through which the clean air supplied to the interior of the work cell is conducted to exit the work cell.

13. The work cell system of claim 12, wherein the passageways conduct the clean air from the bottom of the work cell.

14. The work cell system of claim 12, further comprising:
(a) a floor beneath the work cell, with openings through which the air exiting the work cell can be drawn.

15. The work cell system of claim 14, further comprising:
(a) a return air duct for conducting air from beneath the floor beneath the work cell, to the air handler for cleaning and re-circulation through the work cell.

16. The work cell system of claim 11, wherein the air handler is sized to direct clean air only to the top of the work cell and to a small area surrounding the work cell.

17. A work cell for processing semiconductor wafers in a clean air environment, comprising:
(a) a plurality of work stations disposed within an enclosure for isolating the plurality of work stations from particulates in the environment surrounding the walls;
(b) an opening in the enclosure for admitting clean air into the interior of the work cell.

18. The work cell of claim 17, further comprising:
(a) at least one opening in the enclosure for air to flow from within the enclosure, to the outside of the enclosure.

19. The work cell of claim 18, wherein the opening in the enclosure for admitting clean air, is in the top of the enclosure for receiving downwardly directed clean air.

20. The work cell of claim 19, wherein the opening in the enclosure for air to flow from within the enclosure, is in the bottom of the enclosure for allowing the clean air to pass from the top of the enclosure, through the interior of the enclosure, and out through the bottom of the enclosure.

Figure 1

Figure 2

Figure 3

UNIT 11
— HMDS
— COOL PLATE
— COAT

UNIT 12
— DEVELOP
— SOFT BAKE
— COOL PLATE —→ STEPPER

UNIT 14
— HARD BAKE
— INSPECT STATION

UNIT 15
— FIELD EXPOSE
— POST BAKE
— COOL PLATE

I/O    10

Figure 4

21

22

24

Figure 5

Figure 6a

Figure 6b

Figure 6c

Figure 6d

Figure 6e

Figure 6f

Figure 7

Figure 8

Figure 9

Figure 10

Figure 11

Figure 12

Figure 13